# EUROPÄISCHE PATENTANMELDUNG

(11) **EP 0 753 991 A1**
(43) Veröffentlichungstag der Anmeldung: **15.01.1997**
(21) Anmeldenummer: 96109727.6
(22) Anmeldetag: 18.06.1996
(51) Int. Cl.: H05K 7/14

(54) **Baugruppenträger**

(30) Priorität: 30.06.1995 DE 19523964
(71) Anmelder: Alcatel SEL Aktiengesellschaft, D-70435 Stuttgart (DE)
(72) Erfinder: Hüeber, Fritz, 71665 Vaihingen/Enz (DE)
(74) Vertreter: Schätzle, Albin, Dipl.-Phys.

(57) **Zusammenfassung**

Bei einem Baugruppenträger (1) für einschiebbare Steckbaugruppen sind die Seitenwände (2) durch vier identische, besonders biegesteife Querträger (3) miteinander verbunden. Letztere bestehen jeweils aus zwei unterschiedlich breiten Schienen U-förmigen Querschnitts, die mit den offenen Seiten ineinander gelegt und mit je einem U-Schenkel aneinander genietet sind. In dieser Lage stecken an der Längskante des unbefestigten Schenkels der einen Schiene vorstehende Blechnasen in entsprechenden Schlitzen der anderen Schiene. Die Enden der Querträger (3) haben ferner zwei zueinander rechtwinklig angeordnete Blechlappen, die in entsprechenden Positionierschlitzen der Seitenwände (2) stecken und außerdem einen mit den Seitenwänden (2) verschraubten Befestigungswinkel.

## Beschreibung

Die Erfindung betrifft einen Baugruppenträger zur Aufnahme einschiebbarer Steckbaugruppen für die Verwendung in Einrichtungen der elektrischen und/oder optischen Nachrichtentechnik.

Baugruppenträger der vorliegenden Bauart sind in vielfältigen Ausführungen bekannt. So ist beispielsweise in der Zeitschrift "Elektrisches Nachrichtenwesen, Band 56, Nr. 2/3, 1981,Seiten 283 bis 292", in dem Artikel "System 12 Bauweise" ein Baugruppenträger beschrieben, der aus zwei rechteckigen Seitenwänden besteht, die in den Ecken durch vier Querträger miteinander verbunden sind. In die als Profilschienen ausgebildeten rückwärtigen Querträger sind der Befestigung von Rückwand- Verdrahtungsplatten dienende Lochstreifen eingeschoben. Die aus Blech gefertigten Seitenwände und die aus Strangpreßprofil hergestellten Querträger bestehen aus Aluminium.

Aus der EP-A-0 589 316 ist ein Baugruppenträger bekannt, bei dem die beiden Seitenwände und die beiden hinteren Querträger einstückig aus Stahlblech gebogen sind, wobei die Querträger jeweils einen U-förmigen Querschnitt mit einander zugewandten offenen Seiten haben. Die beiden vorderen Querträger bestehen entweder aus Vierkantprofil oder können jeweils so aus zwei identischen U-Profilen mit den offenen Seiten einander zugewandt ineinander gelegt sein, daß ein U-Schenkel jedes Profils sich in der Mitte zwischen den U-Schenkeln des jeweils anderen Profils befindet. Stirnseitig sind die U-Profile mit Positioniernasen und Zapfen versehen, die mit den Seitenwänden des Baugruppenträgers verschweißt sind.

Der Erfindung liegt die Aufgabe zugrunde, einen kostengünstig herstellbaren Baugruppenträger mit mechanisch besonders biegesteifen Querträgern für den Einbau in bis zu 90 cm breite Gestelle zu schaffen, der insbesondere die Aufnahme hochpoliger und/oder schwergewichtiger Steckeinschübe gestattet. Diese Aufgabe wird erfindungsgemäß durch einen Baugruppenträger mit den Merkmalen des Anspruchs 1 gelöst. Ausgestaltungen des Gegenstandes gemäß Anspruch 1 sind in den Unteransprüchen angegeben. Die mit der gefundenen Lösung erzielbaren Vorteile sind der Beschreibung zu entnehmen.

Die Erfindung wird anhand eines in Zeichnungen dargestellten Ausführungsbeispieles wie folgt näher beschrieben. In den Zeichnungen zeigen:
- Fig. 1: einen Baugruppenträger mit zur Befestigung an rückwärtigen Querträgern vorbereiteten Rückwand-Verdrahtungsplatten, in perspektivischer Ansicht;
- Fig. 2: zwei quergeschnittene Schienen eines Querträgers vor dem Zusammenfügen, in perspektivischer Ansicht;
- Fig. 3: die zu einem Querträger miteinander verbundenen Schienen der Fig. 2, teilweise ausgeschnitten, in perspektivischer Ansicht;
- Fig. 4: einen Querträger vor der Befestigung an einer Seitenwand des Baugruppenträgers, teilweise ausgeschnitten, in perspektivischer Ansicht;
- Fig. 5: eine Seitenwand des Baugruppenträgers der Fig. 1 mit Schlitzen und Löchern zur Positionierung und Befestigung von Querträgern, in perspektivischer Ansicht.

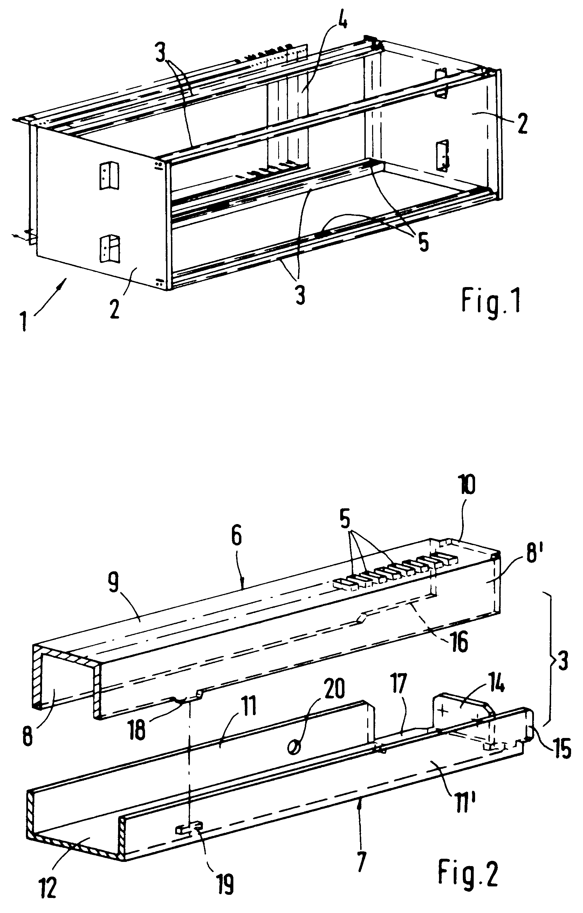

In Fig. 1 ist der Baugruppenträger insgesamt mit 1 bezeichnet. Er besteht im wesentlichen aus zwei Seitenwänden 2 identischer Ausbildung, die in den Ecken durch je einen Querträger 3 miteinander verbunden sind. An den beiden rückwärtigen Querträgern 3 sind mit Steckverbinderleisten bestückte Rückwand- Verdrahtungsplatten 4 befestigt. Außerdem haben die Querträger 3 in einem vorgegebenen Rastermaß angeordnete Durchbrüche 5, die der Befestigung von Führungsleisten für in den Baugruppenträger 1 einschiebbare Steckbaugruppen dienen (nicht dargestellt).

Wie Fig. 2 zeigt, besteht der Querträger 3 aus einer ersten Schiene 6 und einer zweiten Schiene 7, die beide aus Stahlblech hergestellt sind, U-förmigen Querschnitt haben, jedoch eine unterschiedliche Breite aufweisen und bei der Montage mit den offenen Seiten ineinander gelegt werden. Der die U-Schenkel 8,8' verbindende Steg 9 der ersten Schiene 6 enthält die zuvor bereits erwähnten Durchbrüche 5. Außerdem hat er an jedem Ende einen gegenüber den U-Schenkeln 8,8' vorstehenden Blechlappen 10, welche der lagegenauen Positionierung des Querträgers 3 an den Seitenwänden 2 dienen. Der die U-Schenkel 11,11' verbindende Steg 12 der zweiten Schiene 7 ist an jedem Ende nach innen um 90° hochgebogen und bildet einen mit Gewindebohrungen 13 versehenen Befestigungswinkel 14. Der vordere Schenkel 11' dieser Schiene 7 hat an jedem Ende einen gegenüber der Anlagefläche des Befestigungswinkels 14 vorstehenden Blechlappen 15, die ebenfalls zur lagegenauen Positionierung des Querträgers 3 an den Seitenwänden 2 des Baugruppenträgers 1 beitragen und die genau rechtwinklig zu den Blechlappen 10 der ersten Schiene 6 angeordnet sind.

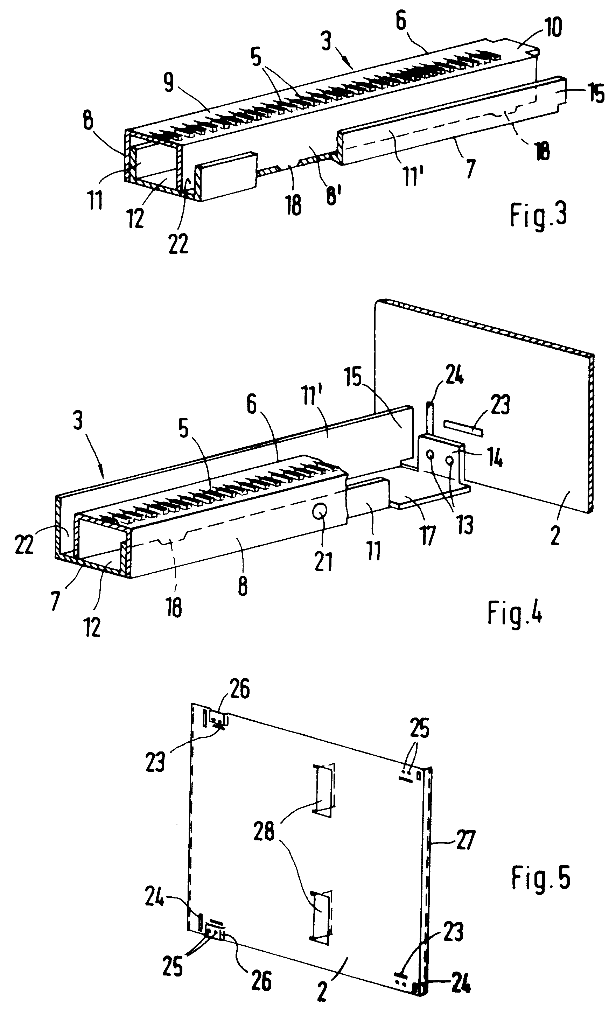

Beim Zusammenfügen der Schienen 6,7 übergreift der in Fig. 2 dargestellte hintere U-Schenkel 8 der ersten Schiene 6 den hinteren U-Schenkel 11 der zweiten Schiene 7, bis die Unterkante einer jeweils am Ende der ersten Schiene 6 vorgesehenen Ausnehmung 16 des U-Schenkels 8 an einem komplementär ausgestellten Blechlappen 17 der zweiten Schiene 7 aufliegt. Der Blechlappen 17 ist jeweils zwischen dem Befestigungswinkel 14 und dem verkürzten Ende des U-Schenkels 11 angeordnet. In dieser Lage befinden sich mehrere, an der unteren Längskante des vorderen U-Schenkels 8' der ersten Schiene 6 in Abständen vorstehende Blechnasen 18 mit in den Abmessungen entsprechend angepaßten Schlitzen 19 im Steg 12 der zweiten Schiene 7 im Eingriff. Die beiden zusammengefügten Schienen 6,7 sind schließlich mittels einiger, über die Länge des Querträgers 3 gleichmäßig verteilter Blindniete 21 (Fig. 4), die im Durchmesser angepaßte Löcher 20 der sich plan berührenden U-Schenkel 8,11 durchsetzen, aneinander befestigt.

Wie eingangs bereits erwähnt wurde, sind die beiden Schienen 6,7 des Querträgers 3 unterschiedlich breit, wodurch zwischen dem innen liegenden, mit Blechnasen 18 versehenen U-Schenkel 8' der ersten Schiene 6 und dem äußeren, sich in parallelem Abstand erstreckenden U-Schenkel 11' der zweiten Schiene 7 eine Nut 22 gebildet ist (Fig. 3 und 4.) Der in Fig. 3 dargestellte Querträger 3 entspricht im Baugruppenträger 1 gemäß Fig. 1 der Einbaulage "vorn unten" und ein gleicher Querträger 3 in spiegelbildlicher Anordnung der Einbaulage "vorn oben". In diesen Fällen bietet die Nut 22 jeweils Raum für den Eingriff von Verriegelungshebeln der vom Baugruppenträger 1 aufzunehmenden Steckbaugruppen. Der in Fig. 4 dargestellte Querträger 3 entspricht im Baugruppenträger 1 der Einbaulage "hinten unten" und ein gleicher Querträger 3 in spiegelbildlicher Anordnung der Einbaulage "hinten oben". Es handelt sich um dieselbe Ausführung wie vorn, jedoch werden die Querträger 3 so um 180° gedreht an den Seitenwänden 2 montiert, daß die äußeren U-Schenkel 11' Anlageflächen für die Rückwand- Verdrahtungsplatten 4 bilden. Deren Befestigung geschieht beispielsweise mittels selbstfurchender Schrauben, für welche die U-Schenkel 11' der rückwärtigen Querträger 3 mit je einer Reihe entsprechender Löcher versehen sind.

Soll der Baugruppenträger 1 mit vorhandenen, relativ kurzen Rückwand- Verdrahtungsplatten 4 bestückt werden, können die U-Schenkel 11' der rückwärtigen Querträger 3 auch so ausgelegt sein, daß sie höher aufragen als die der vorderen Querträger 3. Wie die Fig. 4 und 5 erkennen lassen, haben die Seitenwände 2 des Baugruppenträgers 1 in den vier Ecken je zwei rechtwinklig zueinander angeordnete Schlitze 23,24 und zwei mit den Gewindebohrungen 13 im Befestigungswinkel korrespondierende Löcher 25, beispielsweise für Schrauben M 4. Die in die Schlitze 23,24 gesteckten Blechlappen 10,15 der Querträger 3 sichern die lagegenaue Position in den Seitenwänden 2, bevor sie fest mit den Querträgern 3 verschraubt werden.

Sollen die Köpfe der Befestigungsschrauben versenkt sein, sind die Löcher 25 in entsprechenden Durchdrückungen 26 der Seitenwand 2 angeordnet und die Enden der Querträger 3 darauf abgestimmt. Um eine einheitliche Grundausführung von Querträgern 3 verwenden zu können, werden die Seitenwände 2 zweckmäßigerweise in allen vier Ecken mit Durchdrückungen 26 versehen oder keine, obwohl bei Bedarf natürlich auch beliebig kombinierte Ausführungen vorgesehen werden können. Zur Erhöhung der Stabilität haben die Seitenwände 2 an der Vorderkante eine zur Seite gerichtete Abkantung 27 und außerdem freigeschnittene, nach außen gebogene Befestigungswinkel 28 mit Löchern, die der Montage des Baugruppenträgers 1 in Gestellen oder Schränken dienen.

Der Baugruppenträger 1 mit den Querträgern 3 besteht in vorteilhafter Weise aus nur drei verschiedenen, relativ einfachen Blechstanzteilen, die im kostengünstigen Freibiegeverfahren ihre Endform erhalten. Das Zusammenlegen der beiden Schienen 6,7 und die Herstellung der Nietverbindungen am Querträger 3 sowie die Montage des Baugruppenträgers 1 sind einfachste, in Fabrikation übliche Verrichtungen, die weder besondere Fachkenntnisse noch Spezialwerkzeuge erfordern. Bei gleicher Herstellungs- und Verbindungstechnik kann der Baugruppenträger 1 unter verschiedenen Gesichtspunkten optimiert werden und allein durch die mögliche Materialauswahl verschiedenen Forderungen angepaßt werden.

Voll ausgebaute Steckbaugruppen genormter Abmessungen haben hochpolige Steckerleisten mit bis zu 620 Kontaktelementen und ein beträchtliches Gewicht. Durch den jeweils U-förmigen Querschnitt der aneinander befestigten Schienen 6,7 sowie die Verzahnung der Ausnehmungen 16 mit den ausgestellten Blechlappen 17 und der Blechnasen 18 mit den Schlitzen 19 können die Querträger 3 nicht nur eine hohe Streckenlast aufnehmen, sondern widerstehen auch der beim Einschieben und Herausziehen von Steckbaugruppen auftretenden großen horizontalen Belastung. In dem Baugruppenträger 1 für 90 cm breite Gestelle sind die Querträger 3 üblicherweise 820 mm lang und müssen bei einer Streckenlast von 400 N und einer Beschleunigung von 20 g im Erdbebentest funktionssicher sein. Versuche bestätigen, daß dies mit den beschriebenen Querträgern 3, die wegen der genormten Abmessungen von Baugruppenträgern und den Leiterplatten der Steckbaugruppen relativ flach sein müssen, ohne Schwierigkeiten erreicht wird. Bei Querträgern aus chromatiertem Stahlblech mit einer Streckenlast bis 400 N ist die Durchbiegung < 0,8 mm.

Dies gilt für Querträger 3, bei denen beide Schienen 6,7 aus demselben Material bestehen. Je den nach zu erfüllenden Belastungsanforderungen können die Schienen 6,7 bedarfsweise auch aus nichtrostendem Stahlblech oder aus Aluminiumblech gefertigt werden. Ein weiterer Vorteil ist darin zu sehen, daß auch Baugruppenträger 1 hergestellt werden können, die durch eine Kombination von aus verschiedenen Werkstoffen gefertigten Einzelteilen sowohl belastungs- als auch kostenmäßig optimiert sind. So lassen sich z.B.auch schmalere Baugruppenträger (< 90 cm Breite) mit entsprechend kürzeren Querträgern für Streckenlasten > 600 N fertigen oder bei gleicher verlangter Streckenlast aus billigerem Blech herstellen.

## Patentansprüche

1. Baugruppenträger zur Aufnahme einschiebbarer Steckbaugruppen, mit Seitenwänden und diese in den vier Ecken miteinander verbindenden Querträgern, an denen Führungsschienen für die Steckbaugruppen befestigt sind,
**dadurch gekennzeichnet**, daß die Querträger (3) jeweils aus zwei unterschiedlich breiten Schienen (6,7) U-förmigen Querschitts bestehen, die mit den offenen Seiten ineinander gelegt und mit je einem U-Schenkel (8,11) aneinander befestigt sind, wobei an der Längskante des unbefestigten U-Schenkels (8') der ersten Schiene (6) vorstehende Blechnasen (18) in entsprechende Schlitze (19) im Steg (12) der zweiten Schiene (7) eingreifen.

2. Baugruppenträger nach Anspruch 1, dadurch gekennzeichnet, daß von den aneinander befestigten U-Schenkeln (8,11) beider Schienen (6,7) der U-Schenkel (8) der ersten Schiene (6) an jedem Ende eine Ausnehmung (16) hat und mit der zurückgesetzten Längskante an einem komplementär ausgestellten Blechlappen (17) der zweiten Schiene (7) aufliegt.

3. Baugruppenträger nach Anspruch 1, dadurch gekennzeichnet, daß der Querträger (3) an jedem Ende mit zwei zueinander rechtwinklig angeordneten Blechlappen (10,15) in entsprechende Schlitze (23,24) der Seitenwände (2) des Baugruppenträgers (1) eingesteckt ist und einen mit den Seitenteilen (2) verbundenen Befestigungswinkel (14) aufweist.

4. Baugruppenträger nach Anspruch 1, dadurch gekennzeichnet, daß die aneinander liegenden U-Schenkel (8,11) der beiden Schienen (6,7) des Querträgers (3) durch Blindniete (21) miteinander verbunden sind.

5. Baugruppenträger nach Anspruch 1, dadurch gekennzeichnet, daß die Seitenteile (2) und die Schienen (6,7) der Querträger (3) aus Stahlblech gefertigt sind.
